(19) Europäisches Patentamt
European Patent Office
Office européen des brevets

(11) **EP 3 306 813 B1**

(12) **EUROPEAN PATENT SPECIFICATION**

(45) Date of publication and mention
of the grant of the patent:
**04.05.2022 Bulletin 2022/18**

(51) International Patent Classification (IPC):
*H02P 29/024* (2016.01)    *H02P 27/06* (2006.01)
*G01R 31/34* (2020.01)    *H02H 7/122* (2006.01)
*H02P 29/032* (2016.01)    *G01R 31/52* (2020.01)

(21) Application number: **16802838.9**

(22) Date of filing: **01.02.2016**

(52) Cooperative Patent Classification (CPC):
**H02P 27/06; G01R 31/343; G01R 31/52;
H02H 7/1227; H02P 29/027; H02P 29/032**

(86) International application number:
**PCT/JP2016/052855**

(87) International publication number:
**WO 2016/194399 (08.12.2016 Gazette 2016/49)**

(54) **POWER CONVERSION DEVICE**

STROMWANDLUNGSVORRICHTUNG

DISPOSITIF DE CONVERSION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.06.2015 JP 2015113578**

(43) Date of publication of application:
**11.04.2018 Bulletin 2018/15**

(73) Proprietor: **Hitachi Industrial Equipment Systems
Co., Ltd.**
**Chiyoda-ku
Tokyo 101-0022 (JP)**

(72) Inventors:
• **KAGEYAMA Hiroshi**
**Tokyo 100-8280 (JP)**
• **IBORI Satoshi**
**Tokyo 101-0022 (JP)**
• **SASAKI Yasushi**
**Tokyo 101-0022 (JP)**
• **TOMIYAMA Kiyotaka**
**Tokyo 101-0022 (JP)**

(74) Representative: **Mewburn Ellis LLP**
**Aurora Building
Counterslip
Bristol BS1 6BX (GB)**

(56) References cited:
EP-A2- 2 403 131      JP-A- H06 233 450
JP-A- 2009 201 194      JP-A- 2011 188 653
JP-A- 2012 239 247      JP-B2- 3 657 657
US-A1- 2009 059 446      US-A1- 2013 083 434

EP 3 306 813 B1

**Description**

Technical Field

The present invention relates to a power conversion apparatus and a control method.

Background Art

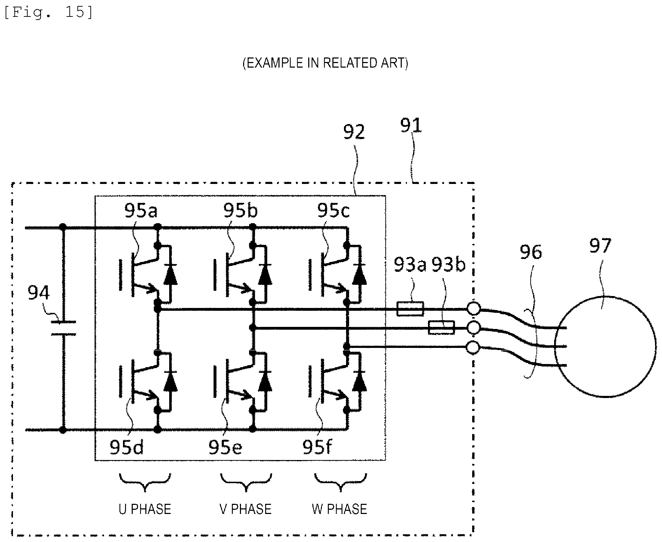

Fig. 15 illustrates a power conversion apparatus in the related art, a motor, and a cable that connects the motor and the power conversion apparatus to each other. A power conversion apparatus 91 includes an inverter circuit 92 that converts direct current for driving the motor into alternating current, current sensors 93a and 93b, and a smoothing capacitor 94. The inverter circuit 92 includes switching elements 95a to 95f that are formed of a semiconductor. Pairs of two switching elements constitute brides in three phases, that is, U, V, and W, respectively. The switching elements for one phase are alternately turned on in such a manner that an upper switching element and a lower switching element are not turned on at the same time. Outputs U, V, and W in the phases, respectively, are connected to the motor 97 using three cables 96, and alternating current is supplied to the motor. In a case where because of some reasons, such as degradation in or physical damage to an insulating coating, an inter-phase short circuit occurs within the motor 97 or on the cable 96, the current sensor 93a or 93b that is present within the power conversion apparatus detects overcurrent. In a case where the overcurrent is detected, by turning off all the switching elements, a conversion operation is stopped and the switching elements are prevented from being damaged due to thermal energy or the like that results from large current.

Furthermore, a method of knowing information on a short circuit point is disclosed in JP-A-10-23795 (PTL 1). In JP-A-10-23795, the following is disclosed. In a case where a slope of a detected current waveform is "0" or is smaller than a reference, it can be diagnosed that an abnormality occurs in a current detection circuit, a switching element, and a winding of a motor, a switching element that is set to be turned on is changed and thus an abnormal point is specified by obtaining a waveform of a current detection circuit. Furthermore, in a case where the slope of the detected current waveform is considerably greater than the reference, it can be diagnosed that a short circuit occurs on a cable or the wiring of the motor.

Citation List

Patent Literature

PTL 1: JP-A-10-23795

US 2013/0083434 A1 proposes a circuit for controlling a load current through a coil which is connected to an output port of a transistor H-bridge that includes two load side transistors and two high side transistors. EP 2 403 131 A2 proposes an electric power conversion system including a motor, an inverter circuit that outputs three-phase alternating current to the motor, a current sensor that detects each of the three-phase alternating currents, and a control circuit that controls the inverter circuit based on a torque command and values detected by the current sensors. US 2009/0059446 A1 proposes an AC motor controller capable of detecting an abnormal state of a motor cable. JP 3657657 B2 proposes a method of determining an abnormality in a power converter using a semiconductor switching element.

Summary of Invention

Technical Problem

In a case where the operation of the power conversion apparatus stops due to the short circuit, the occurrence of the short circuit can be known by reporting information on the stopping of the operation to a user. However, in a case where the operation of the power conversion apparatus stops due to occurrence of a short circuit malfunction, there is a problem in that the user cannot specify a point where the short circuit occurs, that is, whether or not the short circuit malfunction occurs on a cable, or whether or not the short circuit malfunction occurs within a motor.

As the method of knowing the information on the short circuit point, a method in which after the short circuit occurs, two switching elements are turned on in a short time and thus an abnormality is estimated by viewing a slope of current is disclosed in Patent Literature 1. In this case, because the slope of current is determined with inductance L of a short circuit path, it is possible that the short circuit point is estimated based on the inductance L. However, it is difficult to distinguish between the short circuit on the cable and the short circuit within the motor using only information on the inductance L.

Accordingly, an object of the present invention is to provide a power conversion apparatus that determines a short circuit point within a motor and on a cable and reports a result of determination to a user, an external apparatus, or a system. Solution to Problem

According to an aspect of the present invention, there is provided a power conversion apparatus as set out in claim 1. The power conversion apparatus includes a plurality of switching elements and that drives a motor which is connected through a cable, by performing control that turns on and off the plurality of switching element, the apparatus including: an inverter circuit that is configured with a plurality of switching elements that are upper arms for controlling current for a motor and a plurality of switching element that are lower arms; and information output means that reports a situation of the inside of the apparatus to the ouside, in which, when an inter-phase short circuit point that occurs in the motor and the cable is inspected, short circuit current is caused to be generated by turning on the switching elements that are one upper arm and one lower arm which are in different phases, at the same time, and, based on current increasing speed when a short circuit occurs and a current decreasing speed after the short circuit occurs, a short circuit point is determined. Advantageous Effects of Invention

A power conversion apparatus according to the present invention provides an effect in which short circuit current can be caused to be generated by causing specific switching elements to be turned on at the same time to cope with an inter-phase short circuit malfunction that occurs in a motor and on a cable and in which a short circuit point can be specifically determined based on a current increasing speed when a short circuit occurs and a current decreasing speed after the short circuit occurs, and an effect in which a short circuit point can be reported to a user, an external apparatus, or an external system by displaying or wirelessly transmitting a result of the short circuit determination.

Brief Description of Drawings

[Fig. 1] Fig. 1 is a diagram of a configuration of a power conversion apparatus according to a first embodiment of the present invention.
[Fig. 2] Fig. 2 is a diagram illustrating an operational waveform that appears since occurrence of a short circuit in the power conversion apparatus according to the first embodiment of the present invention.
[Fig. 3] Fig. 3 is a diagram illustrating a flowchart of operation of a control circuit for determination of a short circuit position.
[Fig. 4] Fig. 4 is a diagram illustrating an example of a point of a short circuit that occurs on a cable and within a motor.
[Fig. 5] Fig. 5 is a table showing a relationship in magnitude between inductance L and resistance R of a short circuit path with respect to short circuit points A to C that are illustrated in Fig. 4.
[Fig. 6] Fig. 6 is a diagram illustrating a relationship between a state of a switching element in each of the U and W phases and a short circuit current path, which results when the short circuit occurs between the U and W phases.
[Fig. 7] Fig. 7 is a diagram illustrating a result of simulation of a current waveform in a case where the switching element operates, as illustrated in Fig. 6, when a short circuit occurs.
[Fig. 8] Fig. 8 is a diagram illustrating a flowchart for subroutine processing that is invoked by short circuit point determination S32.
[Fig. 9] Fig. 9 is a diagram of configurations of displays 6 and 56.
[Fig. 10] Fig. 10 is a diagram illustrating an operating manual for explaining numbers that are displayed by the displays 6 and 56.
[Fig. 11] Fig. 11 is a diagram of configurations of transmitters 7 and 57.
[Fig. 12] Fig. 12 is a diagram of a configuration of a power conversion apparatus according to a second embodiment of the present invention.
[Fig. 13] Fig. 13 is a diagram of a configuration of a voltage rising detection circuit.
[Fig. 14] Fig. 14 is a diagram illustrating an operational waveform that appears since occurrence of a short circuit in the power conversion apparatus according to the second embodiment of the present invention.
[Fig. 15] Fig. 15 is a diagram illustrating a power conversion apparatus in the related art.
[Fig. 16] Fig. 16 is a diagram illustrating an example where the embodiments find application as inverters for industrial use.
[Fig. 17] Fig. 17 is a diagram illustrating an example where the embodiments find application as railroad vehicles.
[Fig. 18] Fig. 18 is a diagram illustrating an example where the embodiments find application in motorcars, each of which is equipped with an electric motor.
[Fig. 19] Fig. 19 is a diagram illustrating an example where the embodiments find application in air conditioners.

Description of Embodiments

Embodiments will be described below with reference to the drawings, but each embodiment that will be described below is not limited to examples that are illustrated. First Embodiment

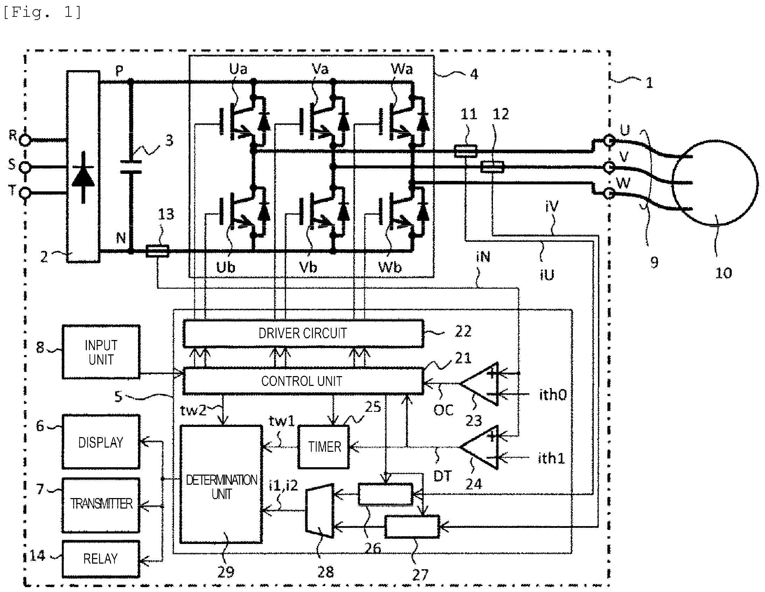

Fig. 1 illustrates a diagram of a configuration of a power conversion apparatus according to a first embodiment of the present invention. A power conversion apparatus 1 includes a rectifier circuit 2 for supplying a motor with alternating current power that is input, a smoothing capacitor 3, and an inverter circuit 4. Furthermore, the power conversion apparatus 1 includes a control circuit 5 for controlling the inverter circuit 4, a display 6 for displaying output information of the control circuit, a transmitter 7 for wirelessly transmitting the output information of the control circuit, a relay output unit 14 for providing an output as an abnormal signal, and an input unit 8 for inputting information into the control circuit. In the present embodiment, the relay output unit 14 for providing the output as the abnormal signal is disclosed, but is not limited to a relay.

The rectifier circuit 2 converts alternating current power that is input from R, S, T terminals into direct current power. The smoothing capacitors 3 are included, as nodes N and P, in direct current voltage wiring that is illustrated. The inverter circuit 4 converts direct current power into alternating current power for driving the motor. The inverter circuit 4 is configured with a semiconductor element that is made from a switching element and a diode which is connected, reversely in parallel, to the switching element. IGBT is used as the switching element in Fig. 1, but the switching element may be configured with MOSFET.

Furthermore, silicon is generally used for a semiconductor device, but silicon carbide (SiC) or gallium nitride (GaN) that is a wide gap semiconductor for loss reduction may be used. The inverter circuit 4 has 6 switching elements, Ua, Ub, Va, Vb, Wa, and Wb. Ua, Va, and Wa are called upper arms, and Ub, Vb, Wb are called lower arms. The switching elements that are the upper arm and the lower arm, for example, Ua and Ub are alternately turned on, and thus control current that is output from an output terminal U. A 3-phase motor 10 is connected to output terminals U, V, and W of the power conversion apparatus 1 through a cable 9, and the motor is driven by current that is output from the output terminals U, V, and W.

Current sensors 11 and 12 are included in wiring that is close to the output terminals U and V, and measure amounts iu and iv of current power that flows out of the output terminals U and V, respectively. It is noted that a current sensor for measuring an amount iW of current that flows out of the output terminal W may also be included in the output terminal W, but that because the amount iW is obtained using iw = -(iu + iv) from an alternating current condition iu + iv + iw = 0, the current sensor is omissible. Furthermore, a phase that is omitted may be U and V instead of W.

Furthermore, a current sensor 13 is included in wiring that is connected to the node N on the direct current side of the inverter circuit 4. The positioning of the current sensor 13 in a position in the drawing makes it possible to measure any current that flows from any of the output terminals U, V, and W into the node N, and because of this, is suitable for quickly performing detection, such as overcurrent detection. It is noted that the power conversion apparatus 1 includes the rectifier circuit 2 in order for alternating current power to be input, but that in a case where direct current power is input, the rectifier circuit 2 may be omitted and the direct current may be input directly into the node P and N.

The control circuit 5 includes a control unit 21 that controls the control circuit 5 with a built-in program that is incorporated in advance, and a driver circuit 22 for driving six transistors of the inverter circuit 4. In normal motor driving, while the control unit 21 feeds back current values that are measured by the current sensors 11 and 12, the driver circuit 22 causes the inverter circuit 4 to perform PWM control. Furthermore, the control circuit 5 includes a comparator 23 that outputs a trigger signal OC when a current threshold ith0 is exceeded, and a comparator 24 that outputs a trigger signal DT when a current threshold ith1 is exceeded.

Furthermore, the control circuit 5 includes a timer 25 that starts to operate with a trigger signal DT of the comparator 24, current measurement circuits 26 and 27 that sample measurement values of the current sensors 11 and 12, and quantify absolute values of amounts of current, a selection circuit 28 that selects the greater of values of the current measurement circuits 26 and 27, and a determination unit 29 that determines a short circuit position. It is noted that it is also possible that elements that are possibly configured only with a logic circuit, such as the control unit 21, the timer 25, the selection circuit 28, the determination unit 29, and the like which are within the control circuit 5, are realized in software with a microcomputer or a programmable logic. Furthermore, because the comparators 23 and 24 have the same function, a configuration in which one comparator is present may be employed by performing a time sharing operation.

In a case where an interphase short circuit occurs between U and V, V and W, or W and U within the motor or on the cable, due to a certain cause, such as degradation of or physical damage to an insulating coating, an amount of overcurrent, which is larger than at the time of the normal motor driving, flows. Regardless of a phase in which a short circuit occurs, overcurrent necessarily flows through the current sensor 13. The comparator 23 transmits the trigger signal OC to the control unit 21 at a point in time at which a current value iN that is measured by the current sensor 13 exceeds the threshold ith0. It is noted that the threshold ith0 is set to be approximately several times a maximum current value and thus that a malfunction due to noise can be prevented.

When detecting a short circuit, the control unit 21 immediately causes the driver circuit 22 to turn off the switching elements Ub, Vb, and Wb, suppresses an increase in short circuit current, and then causes the switching elements Ua, Va, and Wa to be turned off, thereby stopping the short circuit current. It is noted that the threshold ith1 that is supplied to the comparator 24 is a threshold that is used for determination of a short circuit phase that will be described below.

From the perspective of protecting an element, it is desirable that the threshold ith1 is equal to or lower than the threshold ith0 and is a current value so sufficiently high that a phase in which short circuit occurs is determined.

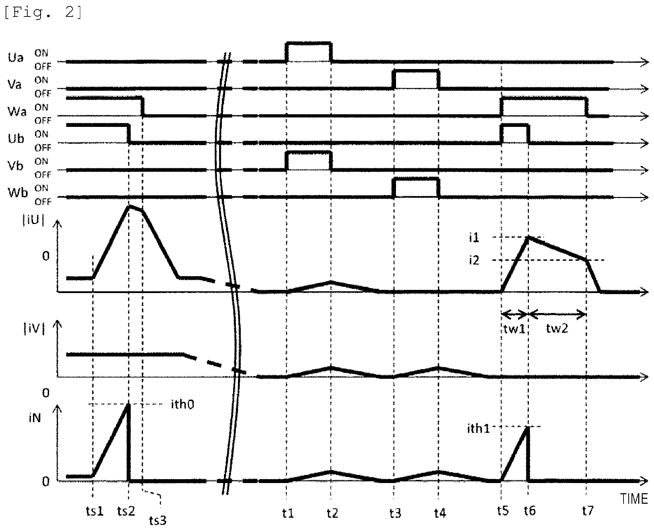

Fig. 2 illustrates an operational waveform that appears since occurrence of a short circuit in the power conversion apparatus according to the first embodiment of the present invention. The vertical axis represents ON and OFF states of the switching elements Ua, Va, Wa, Ub, Vb, and Wb, an absolute value |iU| of a current measurement value iU of the current sensor 11, an absolute value |iV| of a current measurement value iV of the current sensor 12, and a current measurement value iN of the current sensor 13. The horizontal axis represents time. Furthermore, Fig. 2 illustrates an example in a case where a short circuit occurs between W and U at a point in time ts1. When a short circuit occurs at the point in time ts1, the current measurement value iN of the current sensor 13 increases abruptly.

When the threshold ith0 is exceeded at a point in time ts2, the control unit 21 detects the short circuit. When the control unit 21 turns off Ub, Vb, and Wb, an increase in short circuit current stops. When Ua, Va, and Wa are turned off at a point in time ts3, the short circuit current will stop soon. It is noted that in the case of the short circuit between W and U, current iU is current in a negative direction (a direction of flow into the inverter circuit).

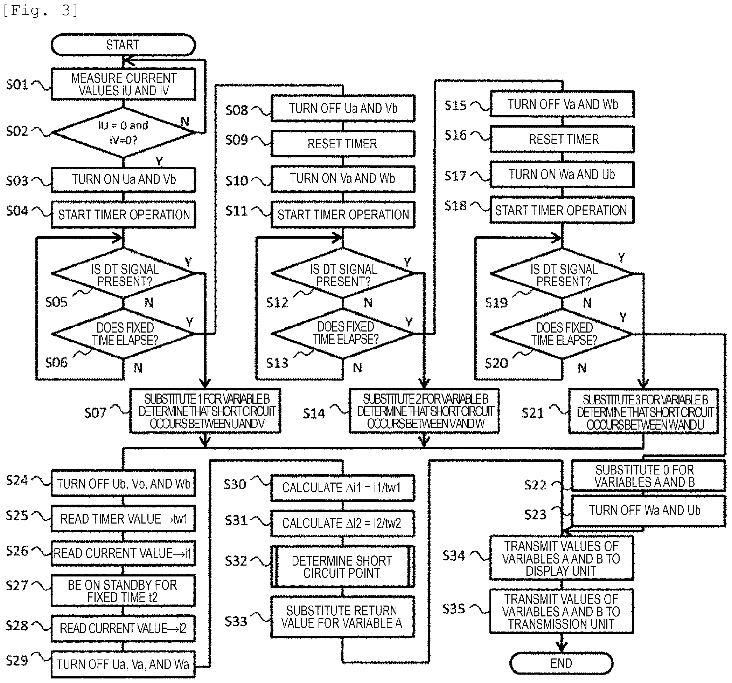

Fig. 3 is a diagram illustrating a flowchart of operation of the control circuit 5 for determination of the short circuit position. The flowchart in FIG. 3 is started after the control circuit 5 detects a short circuit, but may be started according to an external instruction of the input unit 8 in Fig. 1.

First, the control circuit 5 waits until current that flows through the motor or the like is attenuated (S01 and S02) . After current is 0, the switching elements Ua and Vb are turned on and thus the timer 25 starts to operate (S03 and S04 at a point in time t1 in Fig. 2). The control circuit 5 is on standby for a fixed time, and meanwhile, waits for the trigger signal DT from the comparator 24 (S05 and S06).

In a case where there is a short circuit between U and V, because current increases in a short time, the control circuit 5 detects the trigger signal DT in time and substitutes a numerical value 1 denoting that there is a short circuit between U and V for a variable B (S07). In a case where the trigger signal DT is not received with a fixed time, the control circuit 5 determines that there is no short circuit between U and V, turns off the switching element Ua and Vb, and resets a counter 25 (S08 and S09 at a point in time t2 in Fig. 2).

Subsequently, the control circuit 5 turns on the switching elements Va and Wb and thus causes the timer 25 to start to operate (S10 and S11 at a point in time t3 in Fig. 2). Thereafter, the control circuit 5 is on standby for a fixed time, and meanwhile, waits for the trigger signal DT from the comparator 24 (S12 and S13). In a case where there is a short circuit between V and W, because current increases in a short time, the control circuit 5 detects the trigger signal DT in time and substitutes the numerical value 2 denoting that there is a short circuit between V and W for the variable B (S14). In the case where the trigger signal DT is not received with a fixed time, the control circuit 5 determines that there is no short circuit between V and W, turns off the switching element Ua and Vb, and resets the counter 25 (S15 and S16 at a point in time t4 in Fig. 2).

Subsequently, the control circuit 5 turns on the switching elements Wa and Ub and thus causes the timer 25 to start to operate (S17 and S18 at a point in time t5 in Fig. 2). Thereafter, the control circuit 5 is on standby for a fixed time, and meanwhile, waits for the trigger signal DT from the comparator 24 (S19 and S20). In a case where there is a short circuit between W and U, because current increases in a short time, the control circuit 5 detects the trigger signal DT in time and substitutes a numerical value 3 denoting that there is a short circuit between W and U for the variable B (S21). In a case where the trigger signal DT is not received within a fixed time, the control circuit 5 substitutes a variable 0 denoting that there is no short circuit on wiring, or that a short circuit phase is unidentified, for the variable B, and turns off the switching elements Wa and Ub (S22 and S23).

In a case where it is determined that there is a short circuit between each of any phases (S07, S14, and S21), the control circuit 5 immediately turns off the switching elements Ub, Vb, and Wb that are lower arms, and substitutes a counter value of the timer 25 at the same timing for a variable tw1 (S24 and S25 at a point in time t6 in Fig. 2). Furthermore, the current measurement circuits 26 and 27 are caused to sample current values iU and iV of the current sensors 11 and 12 at the same timing. When this is done, the selection circuit 28 outputs the greatest of the absolute values of the current values that are sampled (an absolute value |iU| of the current value iU in a U phase current that flows along a short circuit path, in the case of Fig. 2). The control circuit 5 substitutes the output of the selection circuit 28 for a variable i1 (S26) .

Thereafter, the control circuit 5 is on standby for a fixed time tW2 (S27), again causes the current measurement circuits 26 and 27 to perform the sampling, and substitutes the output of the selection circuit 28 for a variable i2 (S28) . Thereafter, when the switching elements Ua, Va, and Wa that are the upper arms are turned off, current is promptly statically determined (S29 at a point in time t7 in FIG. 2) .

Using current values i1 and i2 that are obtained in the processing described above and times tw1 and tw2, the determination unit 29 of the control circuit 5 calculates current increasing speed $\Delta i1 = i1 \div tw1$ and current decreasing speed $\Delta i2 = \Delta i2 \div tw2$ (S30 and S31). Then, based on current increasing speed $\Delta i1$ and current decreasing speed $\Delta i2$, short circuit point determination processing S32 is performed. A return value to the short circuit point determination processing S32 is substituted for a variable A (S33). The control circuit 5 transmits values of the variable A and the variable B to the display 6 and the transmitter 7 (S34 and S35), and ends the processing for the short circuit point determination.

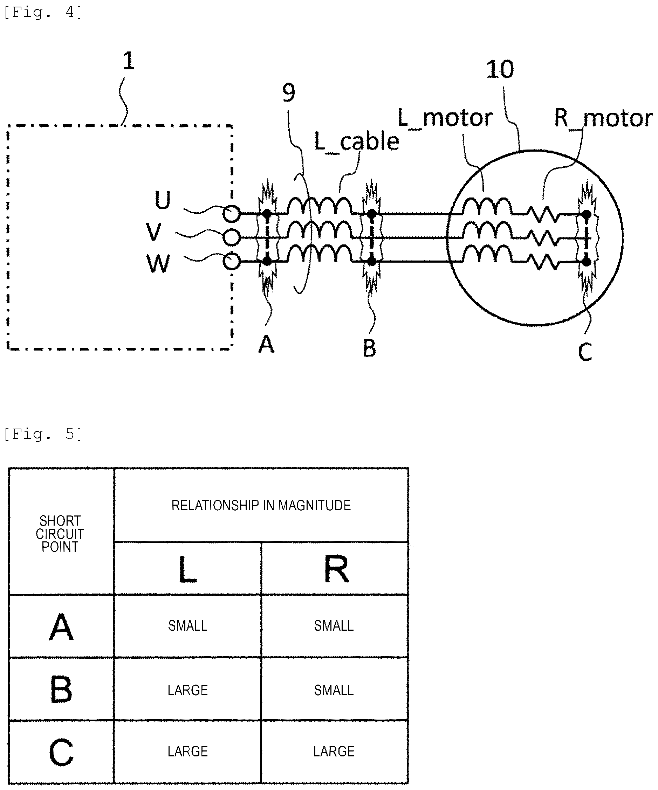

The principle of the determination of the short circuit point by the power conversion apparatus according to the present embodiment will be described below. Fig. 4 is a diagram illustrating an example of a point of a short circuit that occurs on the cable and within the motor. A to C indicate examples of a short circuit occurring point. A is a point of a short circuit that occurs in the vicinity of the power conversion apparatus on the cable, B is a point of a short circuit that occurs in the vicinity of a motor on the cable, and C is a point of a short circuit that occurs within the motor. In a case where impedance between terminals (between U and W in the case of Fig. 4) in a phase in which a short circuit occurs, the inductance L that results when reciprocation takes place along a path from the terminal U to the short circuit point to the terminal W, and impedance of a series circuit with resistance R are observed.

Fig. 5 is a table showing a relationship in magnitude between the impedance L and the resistance R of the short circuit path with respect to the short circuit points A to C that are illustrated in Fig. 4. In a case where a short circuit point is A, because a short circuit at this short circuit point is a short circuit along the shortest path, not only L but also R is the lowest. In a case where a short circuit point is B, because inductance L_cable corresponding to reciprocation on the cables is included in the path, inductance L is relatively high. In a case where a short circuit point is C, not only inductance L_motor of wiring within the motor, but also coil resistance R_motor are included in the path, not only L, but also R is relatively high. Therefore, the short circuit points A to C can be determined based on the relationship in magnitude between L and R.

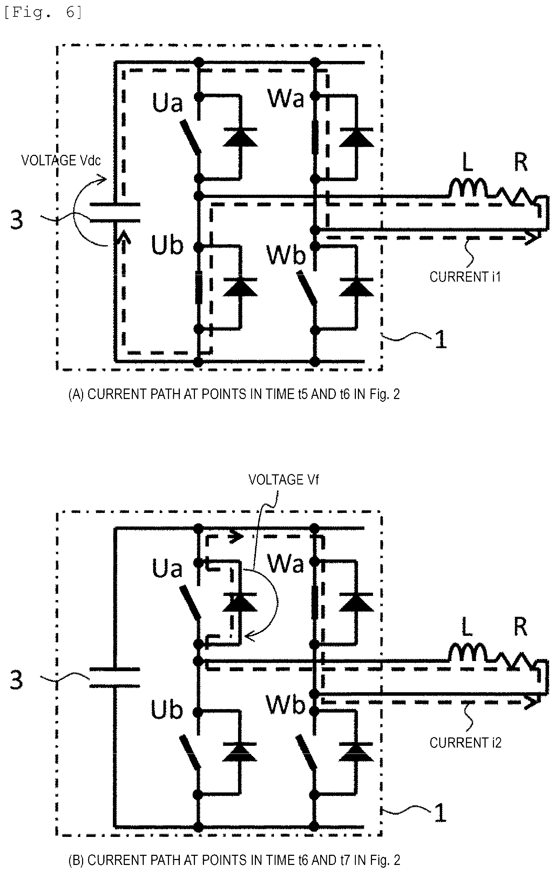

Fig. 6 is a diagram illustrating a relationship between a state of a switching element in each of the U and W phases and a short circuit current path which results when the short circuit occurs between the U and W phases. The inductance L and the resistance R represent inductance and resistance, respectively, on the short circuit path. Fig. 6(A) illustrates a state where the switching element Ub that is the lower arm, in the U phase and the switching element Wa that is the upper arm, in the W phase are turned on, which is a state at each of the points in time t5 to t6 in Fig. 2. When it comes to current i1 that flows along the short circuit path in the state in Fig. 6(A), current increases at a current increasing speed that is represented by Δi1 in an equation in Math. 1.

$$(Math.\ 1)$$

$$\Delta i1 = Vdc/L \cdot \exp(-R \cdot t/L)$$

where Vdc denotes direct current of the smoothing capacitor, L denotes inductance of the short circuit path, and R denotes resistance of the short circuit path. Normally, because the resistance R of the short circuit path is resistance of a cable or winding, a value is considerably low and the term exp(-R·t/L) is almost equal to 1. Therefore, current increasing speed Δi1 is expressed as an equation in Math. 2, and the current increasing speed is determined by the inductance L.

$$(Math.\ 2)$$

$$\Delta i1 = Vdc/L$$

Subsequent to Fig. 6(A), Fig. 6(B) illustrates a state where the switching element Ub that is the lower arm, in the U phase, is turned off, which is a state at each of the points in time t6 and t7 in Fig. 2. In the state in Fig. 6(B), current i2 flows through a loop that results from connecting a reflux diode, L, and R in series, and current i2 decreases at current decreasing speed Δi2 that is expressed in Math. 3.

$$(Math.\ 3)$$

$$\Delta i2 = -(i0 \cdot R + Vf)/L \cdot \exp(-R \cdot t/L)$$

where i0 is an initial value of current, and Vf is forward voltage Vf of the reflux diode.

In the same manner as in the case of the current increasing speed, because the term exp(-R·t/L) can be regarded as being almost equal to 1, the current decreasing speed can be expressed in an equation in Math. 4.

(Math. 4)

$$\Delta i2 = -(i0 \cdot R + Vf)/L$$

wherein, when $\Delta 2/\Delta i1$ that is a ratio between current decreasing speed $\Delta i2$ and current increasing speed $\Delta i1$ is obtained, Math. 5 results.

(Math. 5)

$$\Delta i2/\Delta i1 = -(i0 \cdot R + Vf)/Vdc$$

Therefore, because the magnitude of $\Delta i2/\Delta i1$ is determined by R, the resistance R of the short circuit path can be estimated from a value of $\Delta i2/\Delta i1$.

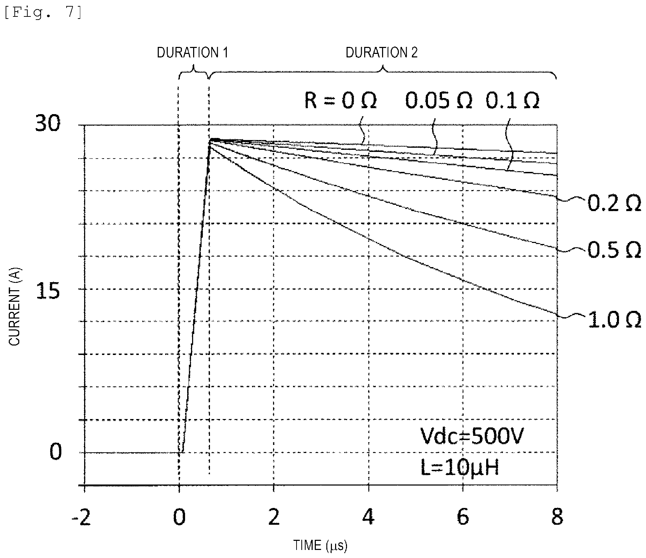

Fig. 7 illustrates a result of simulation of a current waveform in a case where the switching element operates, as illustrated in Fig. 6, when a short circuit occurs. The resistance R of the short circuit path is changed from 0 Q to 1.0 $\Omega$ with direct current voltage Vdc as 500 V and the inductance L of the short circuit path as 10 $\mu$H. During a duration of 0.6 $\mu$s that is indicated by a duration 1, current that flows along the short circuit path is increased with the switching element being set to be in the state in Fig. 6(a). During a duration 2 thereafter, the current that flows along the short circuit path is decreased with the switching element being set to be in the state in Fig. 6 (A). A waveform in Fig. 7 illustrates that current increasing speed $\Delta i1$ during the duration A is almost fixed without depending on the resistance R, that the current decreasing speed during the duration B changes depending on the resistance R that is lower than 1 Q, and that a resistance value of the short circuit path can be accurately estimated by acquiring current decreasing speed $\Delta i2$.

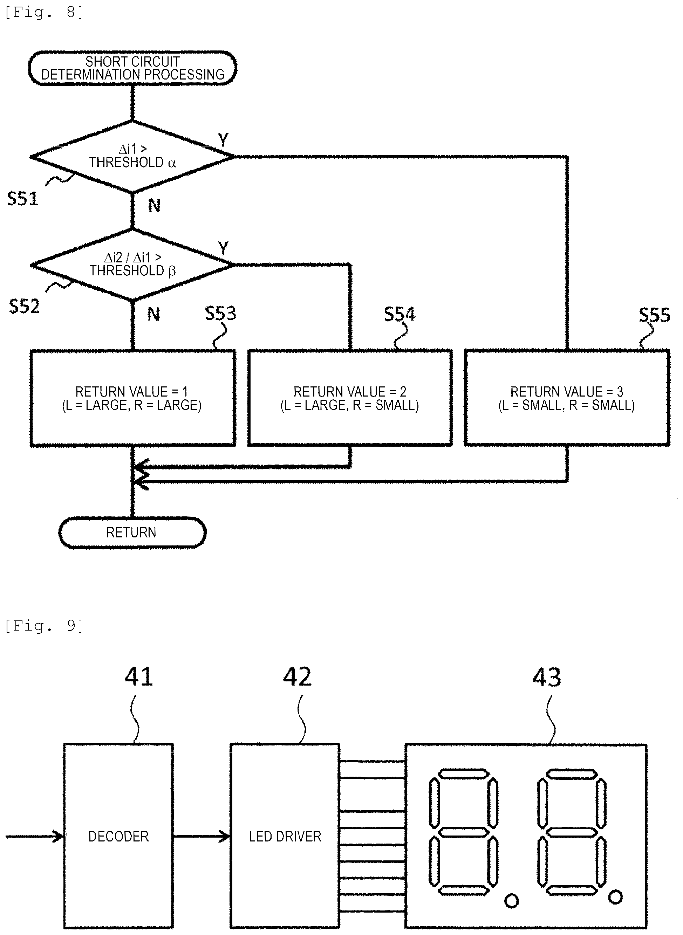

Fig. 8 illustrates a flowchart for subroutine processing that is invoked by the short circuit point determination S32 which is illustrated in the flowchart in Fig. 3. In a case where current changing speed $\Delta i1$ is higher than a predetermined threshold $\alpha$, return value 3 meaning that it is determined that L is low is returned (S55) . In a case where current changing speed $\Delta i1$ is lower than the predetermined threshold $\alpha$ and where $\Delta i2/\Delta i1$ is greater than a predetermined threshold $\beta$, return value 2 meaning that it is determined that L is high and R is low is returned (S54) . In a case where current changing speed $\Delta i1$ is lower than the predetermined threshold $\alpha$ and where $\Delta i2/\Delta i1$ is lower than the predetermined threshold $\beta$, return value 1 meaning that it is determined that L is high and R is high is returned (S53).

The predetermined thresholds $\alpha$ and $\beta$ are numerical values that are experimentally obtained using an inductance value and a resistance value of each of the cable and the motor, numerical values that are obtained in a design aspect using Math. 2 and Math. 4, or numerical values that are obtained from an inductance value and a resistance value which are obtained by an auto-tuning operation at the time of normal driving of the motor.

Fig. 9 illustrates a diagram of a configuration of the display 6. The display 6 is configured with a decoder 41, an LED driver 42, and a two-digit LED segment 43. Values of the variables A and B that are sent from the control circuit 5 are decoded by the decoder 41 into a numerical display pattern for LED segments, and the display pattern is converted into current in the LED driver 42. The LED driver 42 displays the value of the variable A in the first digit of the LED segment 43, and the value of the variable B in the second digit.

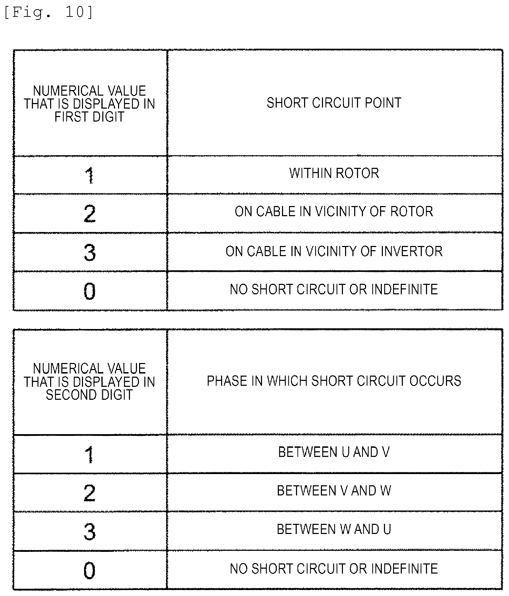

Fig. 10 is a diagram illustrating an operating manual for explaining numbers that are displayed by the display 6. If a numerical value that is displayed in the first digit is 1, this shows a short circuit point is positioned within the motor. If the numerical value is 2, this shows the short circuit point is on the cable in the vicinity of the motor. If the numerical value is 3, this shows that the short circuit point is on the cable in the vicinity of the inverter. Furthermore, if a numerical value that is displayed in the second digit is 1, this shows that the short circuit phase is between U and V. If the numerical value is 2, this shows that the short circuit is between the V and W. If the numerical value is 3, this shows that the short circuit phase is between W and U. It is noted that if the numerical value is 0, this shows that the short circuit is unidentified, or that there is no short circuit.

Furthermore, the LED driver 42 that constitutes the display 6 that is illustrated in Fig. 9 may be a driver for a liquid crystal display, and the LED segment 43 may be a liquid crystal display that is of a matrix display type. In such a case, it is also possible that information which is displayed is set to be a corresponding short circuit point that is illustrated in Fig. 10, instead of the variables A and B.

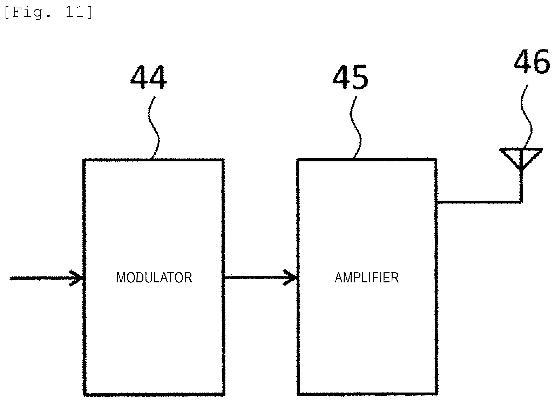

Fig. 11 illustrates a diagram of a configuration of the transmitter 7. The transmitter 7 is configured with a modulator 44, an amplifier 45, and an antenna 46. The values of the variables A and B that are sent from the control circuit 5 are modulated in the modulator 44 and is power-amplified in the amplifier 45. The resulting values are wirelessly transmitted by the antenna 46 to the outside. Although not illustrated, it is possible that another apparatus or another system receives and demodulates a signal which is wirelessly transmitted, and thus that acquires the values of the variables A and B and obtains information on the short circuit point.

Second Embodiment

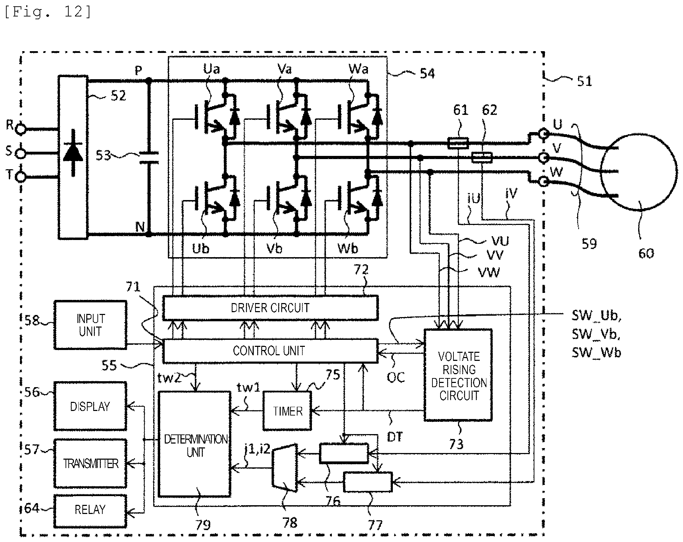

Fig. 12 illustrates a diagram of a configuration of a power conversion apparatus according to a second embodiment of the present invention. A power conversion apparatus 51 includes a rectifier circuit 52 for supplying a motor with alternating current power that is input, a smoothing capacitor 53, and an inverter circuit 54. Furthermore, the power conversion apparatus 51 includes a control circuit 55 for controlling the inverter circuit 54, a display 56 for displaying the output information of the control circuit, a relay output unit 64 for outputting the abnormal signal, a transmitter 57 for wirelessly transmitting the output information of the control circuit, and an input unit 58 for inputting information into the control circuit.
In the present embodiment, the relay output unit 64 for providing the output as the abnormal signal is also disclosed, but is not limited to the relay.
The rectifier circuit 52 converts alternating current power that is input from R, S, T terminals into direct current power. The smoothing capacitors 53 are included, as nodes N and P, in direct current voltage wiring that is illustrated. The inverter circuit 54 converts direct current power into alternating current power for driving the motor. The inverter circuit 54 is configured with a semiconductor element that is made from a switching element and a diode which is connected, reversely in parallel, to the switching element.
The inverter circuit 54 has 6 switching elements, Ua, Ub, Va, Vb, Wa, and Wb. Ua, Va, and Wa are called upper arms, and Ub, Vb, Wb are called lower arms. The switching elements that are the upper arm and the lower arm, for example, Ua and Ub are alternately turned on, and thus control current that is output from an output terminal U. A 3-phase motor 60 is connected to output terminals U, V, and W of the power conversion apparatus 51 through a cable 59, and the motor is driven by current that is output from the output terminals U, V, and W.
Current sensors 61 and 62 are included in wiring that is close to the output terminals U and V, and measure amounts iu and iv of current that flows out of the output terminals U and V, respectively. It is noted that a current sensor for measuring an amount iW of current that flows out of the output terminal W may also be included in the output terminal W, but that because the amount iW is obtained using iw = -(iu + iv) from an alternating current condition iu + iv + iw = 0, the current sensor is omissible. Furthermore, a phase that is omitted may be U and V instead of W.
It is noted that the power conversion apparatus 51 includes the rectifier circuit 52 in order for alternating current power to be input, but that in a case where direct current power is input, the rectifier circuit 52 may be omitted and the direct current power may be input directly into the node P and N.
The control circuit 55 includes a control unit 71 that controls the control circuit 55 with a built-in program that is incorporated in advance, and a driver circuit 72 for driving six transistors of the inverter circuit 54. In normal motor driving, while the control unit 71 feeds back current values that are measured by the current sensors 61 and 62, the driver circuit 72 causes the inverter circuit 54 to perform PWM control.
Furthermore, the control circuit 55 includes a voltage rising detection circuit 73 for detecting the alternating current side output of the inverter circuit 54, more precisely, a rise in a voltage of each of the output terminals U, V, and W. Two voltage thresholds are set to be within the voltage rising detection circuit. When voltages VU, VV, and VW of the output terminals U, V, and W exceed these two thresholds, the trigger signals OC and DT are output.
Furthermore, the control circuit 55 includes a timer 75 that starts to operate with a trigger signal DT, current measurement circuits 76 and 77 that sample measurement values of the current sensors 61 and 62, and quantify absolute values of amounts of current, a selection circuit 78 that selects the greater of values of the current measurement circuits 76 and 77, and a determination unit 79 that determines a short circuit position. It is noted that it is also possible that elements that is possibly configured only with a logic circuit, such as the control unit 71, timers 73 and 24, the selection circuit 28, the determination unit 29, and the like which are within the control circuit 55, are realized in software with a microcomputer or a programmable logic.

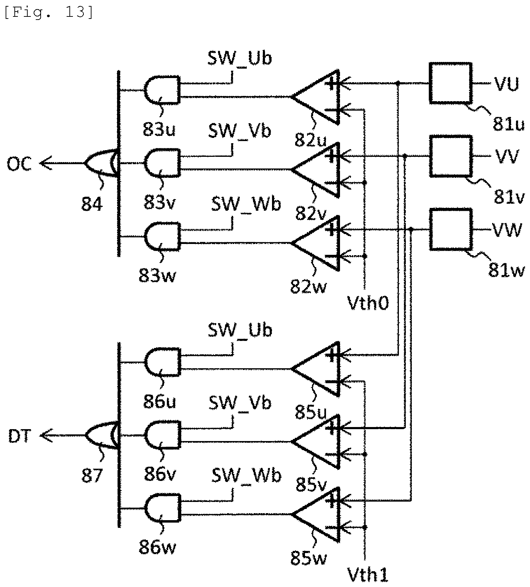

Fig. 13 illustrates a diagram of a configuration of the voltage rising detection circuit. The voltage rising detection circuit 73 is configured with overvoltage protection circuits 81u, 81v, and 81w for cutting a voltage other than an input rating voltage of a comparator, comparators 82u, 82v, 82w, 85u, 85v, and 85w, AND gates 83u, 83v, 83w, 86u, 86v, and 86w, and OR gates 84 and 87.
VthO is a threshold for short circuit protection, and Vth1 is a threshold for short circuit phase determination. The comparator detects voltage rising by voltages VU, VV, and VW of output terminals exceeding the threshold, and output a high signal. However, even in a case where the switching elements Ub, Vb, and Wb that are the lower arms of the inverter 54 is turned off, because the voltage of the output terminal rises, there is a need to mask voltage rising detection that depends on this. With a signal for controlling the turning-on and -off of the switching elements Ub, Vb, and Wb that are the lower arms, which is sent from the control unit 71, the AND gate applies a mast to an output signal of the comparator. In a case where the voltage rising is detected in any terminal among the output terminals with the voltages VU, VV, and VW, the trigger signal OC and DT are output from the OR gates 84 and 87, respectively.

It is noted that because the comparators 82u and 85u have the same function, a configuration in which one comparator is present may be employed by performing the time sharing operation. Furthermore, this is true for the comparator 82v and 85v and the comparator 82w and 85w.

In the case where the interphase short circuit occurs between U and V, V and W, or W and U within the motor or on the cable, due to a certain cause, such as the degradation of or the physical damage to an insulating coating, an amount of overcurrent, which is larger than at the time of the normal motor driving, flows. In a state where overcurrent flows through the switching element that is the lower arm in an ON state, because an operating point of the switching element enters a saturation range, a terminal voltage increases abruptly.

The voltage rising detection circuit 73 transmits the trigger signal OC to the control unit 71 at a point in time at which the increased voltage of the voltage rising detection circuit 73 exceeds a threshold VthO. When detecting a short circuit, the control unit 71 immediately causes the driver circuit 72 to turn off the switching elements Ub, Vb, and Wb, suppresses an increase in short circuit current, and then causes the switching elements Ua, Va, and Wa to be turned off, thereby stopping the short circuit current. It is noted that the threshold Vth1 is a threshold which is used for the determination of the short circuit phase that will be described below. From the perspective of protecting an element, it is desirable that the threshold Vth1 is equal to or lower than the threshold VthO and is a voltage value so sufficiently high that a phase in which short circuit occurs is determined.

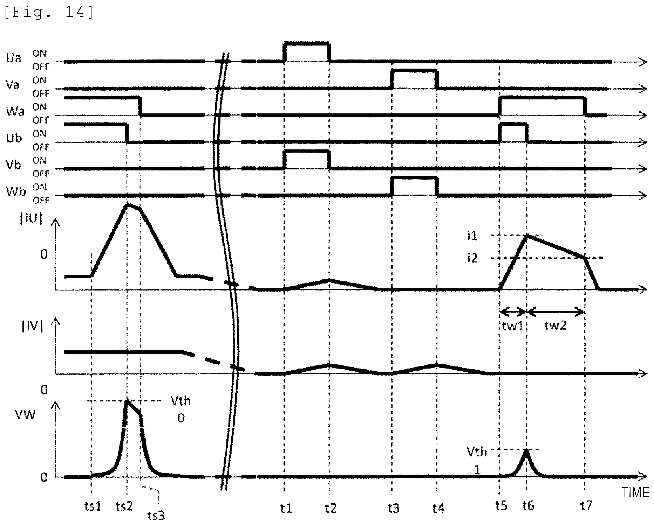

Fig. 14 illustrates an operational waveform that appears since occurrence of a short circuit in the power conversion apparatus according to the second embodiment of the present invention. The vertical axis represents the ON and OFF states of the switching elements Ua, Va, Wa, Ub, Vb, and Wb, the absolute value |iU| of the current measurement value iU of the current sensor 61, the absolute value |iV| of the current measurement value iV of the current sensor 62, and the voltage VW of the output terminal W. The horizontal axis represents time. Furthermore, Fig. 14 illustrates the example in the case where a short circuit occurs between W and U at the point in time ts1. When a short circuit occurs at the point in time ts1, the voltage VW of the output terminal W increases abruptly. When the threshold VthO is exceeded at the point in time ts2, the control unit 71 detects the short circuit.

When the control unit 71 turns off Ub, Vb, and Wb, an increase in short circuit current stops. When Ua, Va, and Wa are turned off at the point in time ts3, the short circuit current will stop soon. It is noted that in the case of the short circuit between W and U, the current iU is current in a negative direction (the direction of flow into the inverter circuit).

Because an operation for the short circuit point determination is the same as that in the first embodiment of the present invention, a description thereof is omitted. The control circuit 55 can realize the same function as in the first embodiment by operating according to the flowchart that is illustrated in Figs. 3 and 8. Furthermore, the display 56 has the same configuration as illustrated in Fig. 9, and the transmitter 57 has the same configuration as illustrated in Fig. 11.

[Application Example of the Invention]

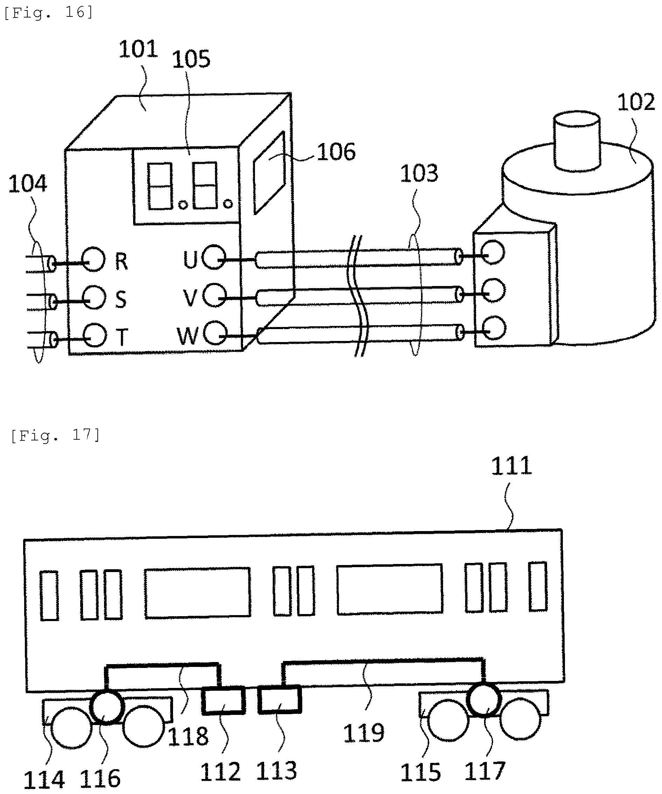

Fig. 16 illustrates an example where the embodiments described above find application as inverters for industrial use. A cable 103 is connected between a power conversion apparatus 101 and a motor 102 for driving. The power conversion apparatus 101 is supplied with power from the outside through alternating current power source wiring 104. The motor 102 is used for driving various industrial apparatuses, such as an air conditioner, a compressor, a conveyor, and an elevator.

In a case where a short circuit occurs within the motor 102 or on the cable 103, information on a short circuit point is displayed on a display 105 that is included in the power conversion apparatus 101, and along with this, the short circuit point is notified to an external system through wireless transmission. Furthermore, numbers that are displayed on the display 105 and a correspondence table 106 for the short circuit points are attached to the power conversion apparatus 101.

Fig. 17 illustrates an example in which the embodiments described above find application in railroad vehicles. Power conversion apparatuses 112 and 113 according to the present embodiment are installed under a floor of the railroad vehicle 111. Motors 116 and 117 for driving are included in trucks 114 and 115 of the railroad vehicle 111. The motor and the power conversion apparatus are connected to each other through cables 118 and 119. In a case where a short circuit occurs within each of the motors 116 and 117 or on each of the cables 118 and 119, information on a short circuit point is displayed on a display that is included in each of the power conversion apparatuses 112 and 113, and along with this, the short circuit point is reported to an external system through wireless transmission.

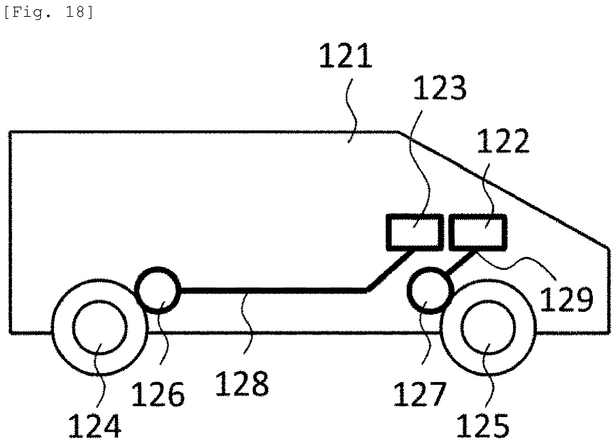

Fig. 18 illustrates an example in which the embodiments described above find application in motorcars, each of which is equipped with an electric motor. The power conversion apparatuses 122 and 123 according to the present embodiment are installed within a motorcar 121. Furthermore, the motors 126 and 127 for driving wheels 124 and 125 are installed, and are connected to the power conversion apparatus through cables 128 and 129. In the case where a short circuit occurs within each of the motors 126 and 127 or on each of the cables 128 and 129, information on a short circuit point is displayed on a display that is included in each of the power conversion apparatuses 122 and 123, and along with this, the short circuit point is reported to an external system through wireless transmission.

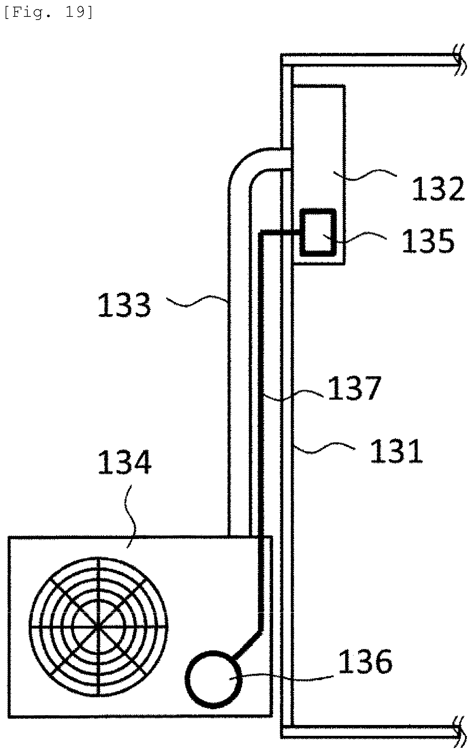

Fig. 19 illustrates an example in which the embodiments described above find application in air conditioners. The air condition is configured with a main body unit 132 that is attached to a wall 131 of a building, a pipe 133 through which a coolant circulates, and a compressor unit 134. Furthermore, a power conversion apparatus 135 according to the present embodiment is included in the main body unit 132 of the air conditioner. On the other hand, a motor 136 for driving a compressor is included in the compressor unit 134, and a cable 137 is connected between the motor and the power conversion apparatus. In a case where a short circuit occurs within the motor 136 or on the cable 137, information on a short circuit point is displayed on a display that is included in the power conversion apparatus 135, and along with this, the short circuit point is notified to an external system through wireless transmission.

Reference Signs List

| | |
|---|---|
| 1 | POWER CONVERSION APPARATUS |
| 2 | RECTIFIER CIRCUIT |
| 3 | SMOOTHING CAPACITOR |
| 4 | INVERTER CIRCUIT |
| 5 | CONTROL CIRCUIT |
| 6 | DISPLAY |
| 7 | TRANSMITTER |
| 8 | INPUT UNIT |
| 9 | CABLE |
| 10 | 3-PHASE MOTOR |
| 11 to 13 | CURRENT SENSOR |
| 14 | RELAY OUTPUT UNIT |
| 21 | CONTROL UNIT |
| 22 | DRIVER CIRCUIT |
| 23, 24 | COMPARATOR |
| 25 | TIMER |
| 26, 27 | CURRENT MEASUREMENT CIRCUIT |
| 28 | SELECTION CIRCUIT |
| 29 | DETERMINATION UNIT |
| 41 | DECODER |
| 42 | LED DRIVER |
| 43 | LED SEGMENT |
| 44 | MODULATOR |
| 45 | AMPLIFIER |
| 51 | POWER CONVERSION APPARATUS |
| 52 | RECTIFIER CIRCUIT |
| 53 | SMOOTHING CAPACITOR |
| 54 | INTERVER CIRCUIT |
| 55 | CONTROL UNIT |
| 56 | DISPLAY |
| 57 | TRANSMITTER |
| 58 | INPUT UNIT |
| 59 | CABLE |
| 60 | 3-PHASE MOTOR |
| 61, 62 | CURRENT SENSOR |
| 64 | RELAY OUTPUT UNIT |
| 71 | CONTROL UNIT |
| 72 | DRIVER CIRCUIT |
| 73 | VOLTAGE RISING DETECTION CIRCUIT |
| 75 | TIMER |
| 76, 77 | CURRENT MEASUREMENT CIRCUIT |
| 78 | SELECTION CIRCUIT |
| 79 | DETERMINATION UNIT |
| 81u to 81w | OVERVOLTAGE PROTECTION CIRCUIT |
| 82u to 82w | COMPARATOR |

| 83u to 83w | AND GATE |
| 84 | OR GATE |
| 85u to 85w | COMPARATOR |
| 86u to 86w | AND GATE |
| 87 | OR GATE |
| 91 | POWER CONVERSION APPARATUS |
| 92 | INVERTER CIRCUIT |
| 93a, 93b | CURRENT SENSOR |
| 94 | SMOOTHING CAPACITOR |
| 95a to 95f | SWITCHING ELEMENT |
| 96 | CABLE |
| 97 | MOTOR |
| 101 | POWER CONVERSION APPARATUS |
| 102 | MOTOR FOR DRIVING |
| 103 | CABLE |
| 104 | ALTERNATING CURRENT POWER SOURCE WIRING |
| 105 | DISPLAY |
| 106 | CORRESPONDENCE TABLE |
| 111 | RAILROAD VEHICLE |
| 112, 113 | POWER CONVERSION APPARATUS |
| 114, 115 | TRUCK |
| 116, 117 | MOTOR |
| 118, 119 | CABLE |
| 121 | AUTOCAR |
| 122, 123 | POWER CONVERSION APPARATUS |
| 124, 125 | WHEEL |
| 126, 127 | MOTOR |
| 128, 129 | CABLE |
| 131 | WALL |
| 132 | MAIN BODY UNIT OF AIR CONDITIONER |
| 133 | PIPE |
| 134 | COMPRESSOR UNIT |
| 135 | POWER CONVERSION APPARATUS |
| 136 | MOTOR |
| 137 | CABLE |
| Ua, Va, Wa | SWITCHING ELEMENTS THAT ARE UPPER ARMS |
| Ub, Vb, Wb | SWITCHING ELEMENTS THAT ARE LOWER ARMS |

**Claims**

1. A power conversion apparatus (1) that includes a plurality of switching elements (Ua, Ub, Va, Vb, Wa, Wb) and that drives a motor (10) which is connected through a cable (9), by performing control that turns on and off the plurality of switching element, the power conversion apparatus comprising:

   an inverter circuit (4) that is configured with a plurality of switching elements that are upper arms (Ua, Va, Wa) for controlling current for the motor and a plurality of switching elements that are lower arms (Ub, Vb,Wb); and
   a determination unit (29) that determines a short circuit point,
   wherein, when an inter-phase short circuit point that occurs in the motor and the cable is inspected, the determination unit causes a short circuit current to be generated by turning on, at the same time, the switching elements that are one upper arm and one lower arm which are in different phases and, based on a current increasing speed, $\Delta i1$, when a short circuit occurs and a current decreasing speed, $\Delta i2$, after the short circuit occurs, determines the short circuit point
   wherein the current increasing speed and current decreasing speed are current change rates, **characterized in that** the determination unit is configured to determine the short circuit point by:

      determining a first value when $\Delta i1$ is lower than a first predetermined threshold and $\Delta i2/\Delta i1$ is lower than a second predetermined threshold, the first value indicating that the short circuit point is positioned within the motor;

determining a second value when $\Delta i1$ is lower than the first predetermined threshold and $\Delta i2/\Delta i1$ is higher than the second predetermined threshold, the second value indicating that the short circuit point is on the cable in the vicinity of the motor; or

determining a third value when $\Delta i1$ is greater than the first predetermined threshold, the third value indicating that the short circuit point is on the cable in the vicinity of the inverter.

2. The power conversion apparatus of claim 1,

wherein the inverter circuit is a 3-phase inverter circuit that is configured with three switching elements that are upper arms for controlling 3-phase current for the motor, and three switching elements that are lower arms; and

wherein the determination unit turns on one switching element that is any of the upper arms, and one switching element that is any of the lower arms, which is different in phase from the one switching element, in a first duration, turns off one of the switching elements that are the upper arms or the lower arms, which are turned on, in a second duration, and

wherein the determination unit determines the short circuit point based on a current increasing speed of output current for the inverter circuit, which is measured during the first duration, and a current decreasing speed of output current for the inverter circuit, which is measured during the second duration.

3. The power conversion apparatus according to claim 1 or 2, further comprising:

information output means (6, 7, 14) for reporting a situation of the inside of the power conversion apparatus to the outside,

wherein the determination unit estimates an inductance value of a short circuit path from the current increasing speed, estimates a resistance value of a short circuit path from the current decreasing speed and the current increasing speed rate, and determines the short circuit point from a relationship in magnitude between the inductance value and the resistance value that are estimated, and

wherein the information output means reports a result of the determination to the outside.

4. The power conversion apparatus according to claim 3,

wherein the information output means is a wireless transmitter (7), and

wherein the information output means transmits a numerical value or a symbol that corresponds to the result of the determination, to the outside.

5. The power conversion apparatus according to claim 3,

wherein the information output means is a display (6) that uses a light emitting element or a liquid crystal element, and

wherein a numerical value, a symbol, or a sentence that corresponds to the result of the determination is displayed on the information output means.

6. The power conversion apparatus according to claim 4, further comprising:
a table that shows a one-to-one correspondence to the short circuit point that corresponds to the numerical value and the symbol.

7. The power conversion apparatus according to claim 1 or 2, further comprising:

a rectifier circuit (2) that performs conversion from alternating current power to direct current power,

wherein the alternating current power that is input from the outside is input into the rectifier circuit and is converted into the direct current power for outputting.

8. The power conversion apparatus according to claim 1 or 2, further comprising:

a plurality of current sensors (11, 12, 13) for measuring current that flows into and out of the inverter circuit; and

a control circuit (5) for controlling operation of the power conversion apparatus,

wherein the control circuit includes

a driver circuit (22) for controlling turning on and off the switching element of the inverter circuit,
a plurality of measurement circuits (26, 27) for sampling current measurement values of the plurality of current sensors, and
a comparator circuit (23, 24) for detecting whether or not current measurement values of the plurality of current sensors exceed a predetermined threshold,

wherein the determination unit calculates the current increasing speed and the current decreasing speed based on a detection time of the comparator circuit and the current measurement value, to determine the short circuit point.

9. The power conversion apparatus according to claim 1 or 2, further comprising:

a plurality of current sensors (11, 12, 13) for measuring current that flows into and out of the inverter circuit; and
a control circuit (5) for controlling operation of the power conversion apparatus,
wherein the control circuit includes

a driver circuit (22) for controlling turning on and off the switching element of the inverter circuit,
a plurality of current measurement circuits (26, 27) for sampling current measurement values of the plurality of current sensors, and
a comparator circuit (23, 24) for detecting whether or not an alternating current side output voltage of the inverter circuit exceeds a predetermined threshold,

wherein the determination unit calculates the current increasing speed and the current decreasing speed based on a detection time of the comparator circuit and the current measurement value, to determine the short circuit point.

10. The power conversion apparatus according to claim 8 or 9,

wherein the control circuit includes an overcurrent detection circuit for detecting overcurrent that exceeds normal motor drive current, and
wherein, the control circuit turns off all the switching elements immediately after the overcurrent detection circuit detects overcurrent, and is on stand by for a fixed time to make a static determination to obtain a state where output current does not flow, and then starts an operation for the determination of the short circuit point.

11. The power conversion apparatus according to claim 8 or 9, further comprising:

an input unit (8) for inputting information from the outside,
wherein the control circuit starts to an operation for the determination of the short circuit point, by being triggered by the input unit.

**Patentansprüche**

1. Leistungswandlungsvorrichtung (1), die eine Vielzahl von Schaltelementen (Ua, Ub, Va, Vb, Wa, Wb) umfasst und einen Motor (10) ansteuert, der über ein Kabel (9) verbunden ist, indem eine Steuerung durchgeführt wird, die die Vielzahl von Schaltelementen ein- und ausschaltet, wobei die Leistungswandlungsvorrichtung Folgendes umfasst:

eine Wechselrichterschaltung (4), die mit einer Vielzahl von Schaltelementen, die obere Zweige (Ua, Va, Wa) zum Steuern eines Stroms für den Motor sind, und einer Vielzahl von Schaltelementen, die untere Zweige (Ub, Vb, Wb) sind, konfiguriert ist; und
eine Bestimmungseinheit (29), die einen Kurzschlusspunkt bestimmt, wobei, wenn ein Zwischenphasenkurzschlusspunkt, der in dem Motor und dem Kabel auftritt, untersucht wird, die Bestimmungseinheit veranlasst, dass ein Kurzschlussstrom durch das gleichzeitige Einschalten der Schaltelemente, die ein unterer Zweig und ein oberer Zweig in unterschiedlichen Phasen sind, erzeugt wird, und basierend auf einer Stromzunahmegeschwindigkeit $\Delta i1$, wenn ein Kurzschluss auftritt, und einer Stromabnahmegeschwindigkeit $\Delta i2$, nachdem der Kurzschluss aufgetreten ist, den Kurzschlusspunkt bestimmt,
wobei die Stromzunahmegeschwindigkeit und die Stromabnahmegeschwindigkeit Stromänderungsraten sind, **dadurch gekennzeichnet, dass** die Bestimmungseinheit konfiguriert ist, um den Kurzschlusspunkt durch Folgendes zu bestimmen:

das Bestimmen eines ersten Werts, wenn $\Delta i1$ niedriger als ein erster vorbestimmter Schwellenwert ist und $\Delta i2/\Delta i1$ niedriger als ein zweiter vorbestimmter Schwellenwert ist, wobei der erste Wert angibt, dass der Kurzschlusspunkt innerhalb des Motors positioniert ist;

das Bestimmen eines zweiten Werts, wenn $\Delta i1$ niedriger als der erste vorbestimmte Schwellenwert ist und $\Delta i2/\Delta i1$ höher als der zweite vorbestimmte Schwellenwert ist, wobei der zweite Wert angibt, dass sich der Kurzschlusspunkt auf dem Kabel in der Nähe des Motors befindet; oder

das Bestimmen eines dritten Werts, wenn $\Delta i1$ größer als der erste vorbestimmte Schwellenwert ist, wobei der dritte Wert angibt, dass sich der Kurzschlusspunkt auf dem Kabel in der Nähe des Wechselrichters befindet.

2. Leistungswandlungsvorrichtung nach Anspruch 1, wobei die Wechselrichterschaltung eine Dreiphasen-Wechselrichterschaltung ist, die mit drei Schaltelementen, die obere Zweige zum Steuern des Dreiphasenstroms für den Motor sind, und drei Schaltelementen, die untere Zweige sind, konfiguriert ist; und

wobei die Bestimmungseinheit ein Schaltelement, das ein beliebiges der oberen Zweige ist, und ein Schaltelement, das ein beliebiges der unteren Zweige ist, das in einer anderen Phase als das eine Schaltelement ist, in einer ersten Zeitspanne einschaltet, und eines der Schaltelemente, die die oberen Zweige oder die unteren Zweige sind, die eingeschaltet sind, in einer zweiten Zeitspanne ausschaltet, und

wobei die Bestimmungseinheit den Kurzschlusspunkt basierend auf einer Stromzunahmegeschwindigkeit eines Ausgangsstroms für die Wechselrichterschaltung, der während der ersten Zeitspanne gemessen wird, und einer Stromabnahmegeschwindigkeit eines Ausgangsstroms für die Wechselrichterschaltung, der während des zweiten Zeitraums gemessen wird, bestimmt.

3. Leistungswandlungsvorrichtung nach Anspruch 1 oder 2, die außerdem Folgendes umfasst:

ein Informationsausgabemittel (6, 7, 14) zum Melden einer Situation vom Inneren der Leistungswandlungsvorrichtung nach außen,

wobei die Bestimmungseinheit einen Induktivitätswert eines Kurzschlusspfads von der Stromzunahmegeschwindigkeit schätzt, einen Widerstandswert eines Kurzschlusspfads von der Stromabnahmegeschwindigkeit und der Stromzunahmegeschwindigkeitsrate schätzt und den Kurzschlusspunkt aus einer Größenbeziehung zwischen dem geschätzten Induktivitätswert und dem geschätzten Widerstandswert bestimmt, und

wobei das Informationsausgabemittel ein Ergebnis der Bestimmung nach außen meldet.

4. Leistungswandlungsvorrichtung nach Anspruch 3,

wobei das Informationsausgabemittel ein drahtloser Sender (7) ist, und

wobei das Informationsausgabemittel einen numerischen Wert oder ein Symbol, der oder das dem Ergebnis der Bestimmung entspricht, nach außen sendet.

5. Leistungswandlungsvorrichtung nach Anspruch 3,

wobei das Informationsausgabemittel eine Anzeige (6) ist, die ein lichtemittierendes Element oder ein Flüssigkristallelement nutzt, und

wobei ein numerischer Wert, ein Symbol oder ein Satz, der oder das dem Ergebnis der Bestimmung entspricht, auf dem Informationsausgabemittel angezeigt wird.

6. Leistungswandlungsvorrichtung nach Anspruch 4, die außerdem Folgendes umfasst:
eine Tabelle, die eine Eins-zu-eins-Korrespondenz zu dem Kurzschlusspunkt aufweist, die dem numerischen Wert und dem Symbol entspricht.

7. Leistungswandlungsvorrichtung nach Anspruch 1 oder 2, die außerdem Folgendes umfasst:

eine Gleichrichterschaltung (2), die eine Umwandlung von Wechselstromleistung zu Gleichstromleistung durchführt,

wobei die Wechselstromleistung, die von außen eingegeben wird, in die Gleichrichterschaltung eingegeben wird und in die Gleichstromleistung zur Ausgabe umgewandelt wird.

8. Leistungswandlungsvorrichtung nach Anspruch 1 oder 2, die außerdem Folgendes umfasst:

eine Vielzahl von Stromsensoren (11, 12, 13) zum Messen des Stroms, der in und aus der Wechselrichterschaltung fließt; und
eine Steuerschaltung (5) zum Steuern des Betriebs der Leistungswandlungsvorrichtung,
wobei die Steuerschaltung Folgendes umfasst:

eine Ansteuerschaltung (22) zum Steuern des Ein- und Ausschaltens des Schaltelements der Wechselrichterschaltung,
eine Vielzahl von Messschaltungen (26, 27) zum Abtasten von Strommesswerten von der Vielzahl von Stromsensoren und
eine Komparatorschaltung (23, 24) zum Detektieren, ob Strommesswerte von der Vielzahl von Stromsensoren einen vorbestimmten Schwellenwert überschreiten,

wobei die Bestimmungseinheit die Stromzunahmegeschwindigkeit und die Stromabnahmegeschwindigkeit basierend auf einer Detektionszeit der Komparatorschaltung und des Strommesswerts berechnet, um den Kurzschlusspunkt zu bestimmen.

9. Leistungswandlungsvorrichtung nach Anspruch 1 oder 2, die außerdem Folgendes umfasst:

eine Vielzahl von Stromsensoren (11, 12, 13) zum Messen des Stroms, der in und aus der Wechselrichterschaltung fließt; und
eine Steuerschaltung (5) zum Steuern des Betriebs der Leistungswandlungsvorrichtung,
wobei die Steuerschaltung Folgendes umfasst:

eine Ansteuerschaltung (22) zum Steuern des Ein- und Ausschaltens des Schaltelements der Wechselrichterschaltung,
eine Vielzahl von Messschaltungen (26, 27) zum Abtasten von Strommesswerten von der Vielzahl von Stromsensoren und
eine Komparatorschaltung (23, 24) zum Detektieren, ob eine wechselstromseitige Ausgangsspannung der Wechselrichterschaltung einen vorbestimmten Schwellenwert überschreitet,

wobei die Bestimmungseinheit die Stromzunahmegeschwindigkeit und die Stromabnahmegeschwindigkeit basierend auf einer Detektionszeit der Komparatorschaltung und des Strommesswerts berechnet, um den Kurzschlusspunkt zu bestimmen.

10. Leistungswandlungsvorrichtung nach Anspruch 8 oder 9,

wobei die Steuerschaltung eine Überstromdetektionsschaltung zur Detektion eines Überstroms umfasst, der einen normalen Motorantriebsstrom überschreitet, und
wobei die Steuerschaltung alle Schaltelemente unmittelbar nach der Detektion des Überstroms durch die Überstromdetektionsschaltung ausschaltet und über einen festen Zeitraum zur Durchführung einer statischen Bestimmung in Bereitschaft ist, um einen Zustand zu erhalten, indem kein Ausgangsstrom fließt, und dann einen Betrieb zur Bestimmung des Kurzschlusspunkts startet.

11. Leistungswandlungsvorrichtung nach Anspruch 8 oder 9, die außerdem Folgendes umfasst:

eine Eingabeeinheit (8) zur Eingabe von Informationen von außen,
wobei die Steuerschaltung ausgelöst durch die Eingabeeinheit einen Betrieb zur Bestimmung des Kurzschlusspunkts startet.

**Revendications**

1. Appareil de conversion de puissance (1) qui comprend une pluralité d'éléments de commutation (Ua, Ub, Va, Vb, Wa, Wb) et qui entraîne un moteur (10) qui est connecté par l'intermédiaire d'un câble (9), en effectuant une commande qui active et désactive la pluralité d'éléments de commutation, l'appareil de conversion de puissance comprenant :

un circuit inverseur (4) qui est configuré avec une pluralité d'éléments de commutation qui sont des bras supérieurs (Ua, Va, Wa) pour commander le courant pour le moteur et une pluralité d'éléments de commutation qui sont des bras inférieurs (Ub, Vb, Wb) ; et
une unité de détermination (29) qui détermine un point de court-circuit,
dans lequel, lorsqu'un point de court-circuit entre phases qui survient au niveau du moteur et des câbles est inspecté, l'unité de détermination amène un courant de court-circuit à être généré en activant simultanément les éléments de commutation qui sont un bras supérieur et un bras inférieur de phases différentes et, sur la base d'une vitesse croissant de courant, $\Delta i1$, lorsqu'un court-circuit survient, et d'une vitesse décroissante de courant, $\Delta i2$, après la survenue du court-circuit, détermine le point de court-circuit.
dans lequel la vitesse croissante de courant et la vitesse décroissante de courant sont des vitesses de changement de courant,
caractérisé en ce
l'unité de détermination est configurée pour déterminer le point de court-circuit par les étapes consistant à :

déterminer une première valeur lorsque $\Delta i1$ est inférieure à un premier seuil prédéterminé et $\Delta i2/\Delta i1$ est inférieur à un second seuil prédéterminé, la première valeur indiquant que le point de court-circuit est positionné à l'intérieur du moteur ;
déterminer une deuxième valeur lorsque $\Delta i1$ est inférieure au premier seuil prédéterminé et $\Delta i2/\Delta i1$ est supérieur au second seuil prédéterminé, la deuxième valeur indiquant que le point de court-circuit est sur le câble à proximité du moteur ; ou
déterminer une troisième valeur lorsque $\Delta i1$ est supérieure au premier seuil prédéterminé, la troisième valeur indiquant que le point de court-circuit est sur le câble à proximité de l'inverseur.

2.  Appareil de conversion de puissance selon la revendication 1,

dans lequel le circuit inverseur est un circuit inverseur triphasé qui est configuré avec trois éléments de commutation qui sont des bras supérieurs pour commander du courant triphasé pour le moteur, et trois éléments de commutation qui sont des bras inférieurs ; et
dans lequel l'unité de détermination active un élément de commutation qui est un quelconque des bras supérieurs, et un élément de commutation qui est un quelconque des bras inférieurs, dont la phase est différente du premier élément de commutation, dans une première durée, désactive un des éléments de commutation qui sont les bras supérieurs ou les bras inférieurs, qui sont activés, dans une seconde durée, et
dans lequel l'unité de détermination détermine le point de court-circuit sur la base d'une vitesse croissante de courant du courant de sortie pour le circuit inverseur, qui est mesurée pendant la première durée, et d'une vitesse décroissante de courant du courant de sortie pour le circuit inverseur, qui est mesurée pendant la seconde durée.

3.  Appareil de conversion de puissance selon la revendication 1 ou 2, comprenant en outre :

des moyens de sortie d'informations (6, 7, 14) pour rapporter une situation de l'intérieur de l'appareil de conversion de puissance vers l'extérieur,
dans lequel l'unité de détermination estime une valeur d'inductance d'un trajet de court-circuit à partir de la vitesse croissante de courant, estime une valeur de résistance d'un trajet de court-circuit à partir de la vitesse décroissante de courant et de la vitesse croissante de courant, et détermine le point de court-circuit à partir d'une relation en amplitude entre la valeur d'inductance et la valeur de résistance qui sont estimées, et
dans lequel les moyens de sortie d'informations rapportent un résultat de la détermination vers l'extérieur.

4.  Appareil de conversion de puissance selon la revendication 3,

dans lequel les moyens de sortie d'informations sont un émetteur sans fil (7), et
dans lequel les moyens de sortie d'informations transmettent une valeur numérique ou un symbole qui correspond au résultat de la détermination, vers l'extérieur.

5.  Appareil de conversion de puissance selon la revendication 3, dans lequel les moyens de sortie d'informations sont un affichage (6) qui utilise un élément électroluminescent ou un élément à cristaux liquides, et
dans lequel une valeur numérique, un symbole ou une phrase qui correspond au résultat de la détermination est affiché(e) sur les moyens de sortie d'informations.

6. Appareil de conversion de puissance selon la revendication 4, comprenant en outre :
une table qui montre une correspondance biunivoque avec le point de court-circuit qui correspond à la valeur numérique et au symbole.

7. Appareil de conversion de puissance selon la revendication 1 ou 2, comprenant en outre :

un circuit redresseur (2) qui effectue une conversion d'une alimentation en courant alternatif en une alimentation en courant continu,
dans lequel l'alimentation en courant alternatif qui est entrée depuis l'extérieur est entrée dans le circuit redresseur et est convertie en alimentation en courant continu pour une délivrance en sortie.

8. Appareil de conversion de puissance selon la revendication 1 ou 2, comprenant en outre :

une pluralité de capteurs de courant (11, 12, 13) pour mesurer du courant qui circule dans et hors du circuit inverseur ; et
un circuit de commande (5) pour commander le fonctionnement de l'appareil de conversion de puissance,
dans lequel le circuit de commande comprend

un circuit d'attaque (22) pour commander l'activation et la désactivation de l'élément de commutation du circuit inverseur,
une pluralité de circuits de mesure (26, 27) pour échantillonner des valeurs de mesure de courant de la pluralité de capteurs de courant, et
un circuit comparateur (23, 24) pour détecter si les valeurs de mesure de courant de la pluralité de capteurs de courant dépassent ou non un seuil prédéterminé,
dans lequel l'unité de détermination calcule la vitesse croissante de courant et la vitesse décroissante de courant sur la base d'un temps de détection du circuit comparateur et de la valeur de mesure de courant, afin de déterminer le point de court-circuit.

9. Appareil de conversion de puissance selon la revendication 1 ou 2, comprenant en outre :

une pluralité de capteurs de courant (11, 12, 13) pour mesurer du courant qui circule dans et hors du circuit inverseur ; et
un circuit de commande (5) pour commander le fonctionnement de l'appareil de conversion de puissance,
dans lequel le circuit de commande comprend

un circuit d'attaque (22) pour commander l'activation et la désactivation de l'élément de commutation du circuit inverseur,
une pluralité de circuits de mesure de courant (26, 27) pour échantillonner des valeurs de mesure de courant de la pluralité de capteurs de courant, et
un circuit comparateur (23, 24) pour détecter si une tension de sortie côté courant alternatif du circuit inverseur dépasse ou non un seuil prédéterminé,

dans lequel l'unité de détermination calcule la vitesse croissante de courant et la vitesse décroissante de courant sur la base d'un temps de détection du circuit comparateur et de la valeur de mesure de courant, afin de déterminer le point de court-circuit.

10. Appareil de conversion de puissance selon la revendication 8 ou 9,

dans lequel le circuit de commande comprend un circuit de détection de surintensité pour détecter une surintensité qui dépasse un courant d'entraînement de moteur normal, et
dans lequel, le circuit de commande désactive tous les éléments de commutation immédiatement après que le circuit de détection de surintensité détecte une surintensité, et est en attente pendant un temps fixe pour effectuer une détermination statique afin d'obtenir un état où un courant de sortie ne circule pas, puis commence une opération pour la détermination du point de court-circuit.

11. Appareil de conversion de puissance selon la revendication 8 ou 9, comprenant en outre :

une unité d'entrée (8) pour entrer des informations à partir de l'extérieur,

dans lequel le circuit de commande commence une opération pour la détermination du point de court-circuit, en étant déclenché par l'unité d'entrée.

[Fig. 1]

EP 3 306 813 B1

[Fig. 2]

[Fig. 3]

START

S01 — MEASURE CURRENT VALUES IU AND IV

S02 — iU = 0 and iV=0? — N / Y

S03 — TURN ON Ua AND Vb

S04 — START TIMER OPERATION

S05 — IS DT SIGNAL PRESENT? — Y / N

S06 — DOES FIXED TIME ELAPSE? — Y / N

S07 — SUBSTITUTE 1 FOR VARIABLE B DETERMINE THAT SHORT CIRCUIT OCCURS BETWEEN U AND V

S08 — TURN OFF Ua AND Vb

S09 — RESET TIMER

S10 — TURN ON Va AND Wb

S11 — START TIMER OPERATION

S12 — IS DT SIGNAL PRESENT? — Y / N

S13 — DOES FIXED TIME ELAPSE? — Y / N

S14 — SUBSTITUTE 2 FOR VARIABLE B DETERMINE THAT SHORT CIRCUIT OCCURS BETWEEN V AND W

S15 — TURN OFF Va AND Wb

S16 — RESET TIMER

S17 — TURN ON Wa AND Ub

S18 — START TIMER OPERATION

S19 — IS DT SIGNAL PRESENT? — Y / N

S20 — DOES FIXED TIME ELAPSE? — Y / N

S21 — SUBSTITUTE 3 FOR VARIABLE B DETERMINE THAT SHORT CIRCUIT OCCURS BETWEEN W AND U

S22 — SUBSTITUTE 0 FOR VARIABLES A AND B

S23 — TURN OFF Wa AND Ub

S24 — TURN OFF Ub, Vb, AND Wb

S25 — READ TIMER VALUE → tw1

S26 — READ CURRENT VALUE → i1

S27 — BE ON STANDBY FOR FIXED TIME t2

S28 — READ CURRENT VALUE → i2

S29 — TURN OFF Ua, Va, AND Wa

S30 — CALCULATE Δi1 = i1/tw1

S31 — CALCULATE Δi2 = i2/tw2

S32 — DETERMINE SHORT CIRCUIT POINT

S33 — SUBSTITUTE RETURN VALUE FOR VARIABLE A

S34 — TRANSMIT VALUES OF VARIABLES A AND B TO DISPLAY UNIT

S35 — TRANSMIT VALUES OF VARIABLES A AND B TO TRANSMISSION UNIT

END

[Fig. 4]

[Fig. 5]

| SHORT CIRCUIT POINT | RELATIONSHIP IN MAGNITUDE | |
|---|---|---|
| | L | R |
| A | SMALL | SMALL |
| B | LARGE | SMALL |
| C | LARGE | LARGE |

[Fig. 6]

(A) CURRENT PATH AT POINTS IN TIME t5 AND t6 IN Fig. 2

(B) CURRENT PATH AT POINTS IN TIME t6 AND t7 IN Fig. 2

[Fig. 7]

[Fig. 8]

```
          ┌─────────────────────┐
          │    SHORT CIRCUIT    │
          │ DETERMINATION PROCESSING │
          └─────────────────────┘
                     │
                     ▼
              ╱─────────────╲          Y
             ╱   Δi1 >       ╲──────────────────────────────┐
        S51  ╲  THRESHOLD α  ╱                              │
              ╲─────────────╱                               │
                     │ N                                    │
                     ▼                                      │
              ╱─────────────╲          Y                    │
             ╱  Δi2 / Δi1 >  ╲──────────────┐               │
        S52  ╲ THRESHOLD β   ╱              │               │
              ╲─────────────╱               │               │
                     │ N   S53          S54 │           S55 │
                     ▼                      ▼               ▼
         ┌──────────────────┐  ┌──────────────────┐  ┌──────────────────┐
         │  RETURN VALUE = 1 │  │  RETURN VALUE = 2 │  │  RETURN VALUE = 3 │
         │(L = LARGE, R = LARGE)│(L = LARGE, R = SMALL)│(L = SMALL, R = SMALL)│
         └──────────────────┘  └──────────────────┘  └──────────────────┘
                     │◄─────────────────────┘               │
                     │◄─────────────────────────────────────┘
                     ▼
              ┌────────────┐
              │   RETURN   │
              └────────────┘
```

[Fig. 9]

```
        41              42                    43
        │               │                     │

   ┌─────────┐     ┌─────────┐        ┌──────────────────┐
   │         │     │         │ ══════ │                  │
──►│ DECODER │ ──► │LED DRIVER│ ══════ │   [8]    [8].    │
   │         │     │         │ ══════ │                  │
   └─────────┘     └─────────┘ ══════ └──────────────────┘
```

[Fig. 10]

| NUMERICAL VALUE THAT IS DISPLAYED IN FIRST DIGIT | SHORT CIRCUIT POINT |
|---|---|
| 1 | WITHIN ROTOR |
| 2 | ON CABLE IN VICINITY OF ROTOR |
| 3 | ON CABLE IN VICINITY OF INVERTOR |
| 0 | NO SHORT CIRCUIT OR INDEFINITE |

| NUMERICAL VALUE THAT IS DISPLAYED IN SECOND DIGIT | PHASE IN WHICH SHORT CIRCUIT OCCURS |
|---|---|
| 1 | BETWEEN U AND V |
| 2 | BETWEEN V AND W |
| 3 | BETWEEN W AND U |
| 0 | NO SHORT CIRCUIT OR INDEFINITE |

[Fig. 11]

44  MODULATOR

45  AMPLIFIER

46

[Fig. 12]

[Fig. 13]

[Fig. 14]

[Fig. 15]

(EXAMPLE IN RELATED ART)

[Fig. 16]

[Fig. 17]

[Fig. 18]

[Fig. 19]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10023795 A
- US 20130083434 A1
- EP 2403131 A2
- US 20090059446 A1
- JP 3657657 B